## Europäisches Patentamt

## European Patent Office

## Office européen des brevets

(19)

(11) Veröffentlichungsnummer: **0 000 475**
**B1**

(12) # EUROPÄISCHE PATENTSCHRIFT

(45) Veröffentlichungstag der Patentschrift:
17.02.82

(51) Int. Cl.³: **H 01 L 35/32**

(21) Anmeldenummer: 78100229.0

(22) Anmeldetag: 23.06.78

(54) **Thermoelektrische Anordnung mit grossen Temperaturgradienten.**

(30) Priorität: 28.07.77 DE 2734022

(43) Veröffentlichungstag der Anmeldung:
07.02.79 Patentblatt 79/3

(45) Bekanntmachung des Hinweises auf die Patenterteilung:
17.02.82 Patentblatt 82/7

(84) Benannte Vertragsstaaten:
**BE CH DE FR GB LU NL SE**

(56) Entgegenhaltungen:
**DE-A-2 547 262**

(73) Patentinhaber: **Dahlberg, Reinhard, Dr., Innere Bergstrasse 32, D-7101 Flein (DE)**

(72) Erfinder: **Dahlberg, Reinhard, Dr., Innere Bergstrasse 32, D-7101 Flein (DE)**

## Thermoelektrische Anordnung mit großen Temperaturgradienten

Die Patentanmeldung beschreibt eine thermoelektrische Anordnung zur Umwandlung von Wärme in elektrische Energie und zum reversiblen Pumpen von Wärme.

Wegen der relativ kleinen Thermokräfte sind die Arbeitsspannung und die spezifische elektrische Leistung von thermoelektrischen Anordnungen im allgemeinen nur klein. Eine Serienschaltung von Thermoelementen vergrößert zwar die Arbeitsspannung, aber sie vergrößert in dem selben Maße auch den Raumbedarf und den Serienwiderstand der thermoelektrischen Anordnungen. Man erreicht mit konventionellen thermoelektrischen Anordnungen nur elektrische Leistungen bis zu etwa 1 Watt/cm³. Außerdem liegen die Wirkungsgrade der thermoelektrischen Energieumwandlung meist weit unter 10%.

In der DE-A-2 547 262 wird eine thermoelektrische Anordnung beschrieben, bei welcher der Wärmestrom durch die Schenkel eines Thermoelementes über so große Temperaturgradienten fließt, daß die spezifische Wärmeleitfähigkeit in den Zonen mit den großen Temperaturgradienten verkleinert ist. Dadurch tritt eine Vergrößerung der Effektivität und als Folge davon eine Verbesserung des thermoelektrischen Wirkungsgrades ein. Ein Nachteil der thermoelektrischen Anordnung gemäß DE-A-2 547 262 ist aber noch ihre relativ kleine Arbeitsspannung.

Der vorliegenden Erfindung liegt die Aufgabe zugrunde, thermoelektrische Anordnungen mit großen Temperaturgradienten anzugeben, welche hohe spezifische elektrische Leistungen bei wesentlich höheren Arbeitsspannungen haben. Erfindungsgemäß sind dazu die Elementschenkel eines Thermoelementes aus Blechen, Folien oder Schichten gebildet, welche die Form von Bändern, Scheiben oder Ringen haben und mechanisch so bewegt sind, daß sie mindestens an einer Stelle ein nichtstationäres Paket bilden, in dem ihre Oberflächen aufeinanderfolgend einander berühren, welches Paket abwechselnd thermoelektrische p/n- und n/p-Übergänge enthält, zwischen denen eine Temperaturdifferenz besteht, und daß ein elektrischer Strom durch das nichtstationäre Paket senkrecht zur Oberfläche der Bleche, Folien oder Schichten fließt.

Im nichtstationären Paket kommen laufend neue heiße und kalte Zonen miteinander in mechanischen und elektrischen Kontakt. In diesen Berührungskontakten bilden sich kurzzeitig Zonen mit großen Temperaturgradienten. Über die mechanische Berührung der sich durch das nichtstationäre Paket bewegenden heißen und kalten Bänder, Scheiben oder Ringe erfolgt ein größerer Wärmetransport, als dies z. B. durch reine Wärmeleitung möglich wäre. Hinzu kommt, daß man die Dicke der Bleche, Folien oder Schichten (aus denen die Bänder, Scheiben oder Ringe gebildet sind) relativ klein machen kann, so daß die Zahl der Thermoelemente, die pro Zentimeter im nichtstationären Paket elektrisch in Serie geschaltet sind, relativ groß sein kann. Schließlich kann man auch den elektrischen Kontaktwiderstand zwischen den Blechen, Folien oder Schichten im nichtstationären Paket über einen hinreichend großen mechanischen Kontaktdruck und durch elektrische Parallelschaltung mehrerer nichtstationärer Pakete relativ klein machen. Als Folge aller dieser Faktoren lassen sich aus der thermoelektrischen Anordnung gemäß der Erfindung spezifische elektrische Spannungen und Leistungen entnehmen, die um Größenordnungen größer sind als bei konventionellen thermoelektrischen Generatoren.

Die Temperaturdifferenzen zwischen benachbarten n/p- und p/n-Übergängen im nichtstationären Paket gemäß der Erfindung lassen sich z. B. dadurch erzeugen, daß thermoelektrisch p- und n-leitende Bleche, Folien oder Schichten nur sehr kurzzeitig auf einer Seite mit Hilfe von Plasma oder Strahlung aufgeheizt werden, und daß das nichtstationäre Paket sofort nach Ereichen der höchsten Oberflächentemperatur durch Zusammenpressen der jeweils heißen bzw. kalten Seiten der Bleche, Folien oder Schichten gebildet wird.

Nach einem anderen Ausführungsbeispiel werden Paare von thermoelektrisch p- und n-leitenden Blechen, Folien oder Schichten, welche sich paarweise auf unterschiedlichen Temperaturen befinden, an einer Stelle zum nichtstationären Paket zusammengeführt.

Da der elektrische Strom senkrecht zur Oberfläche der Bleche, Folien oder Schichten durch das nichtstationäre Paket fließt, läßt sich durch ein Magnetfeld, welches senkrecht zur Richtung des elektrischen Stromes und senkrecht zur Bewegungsrichtung der Schichten angelegt ist, eine mechanische Kraft erzeugen, welche die Bleche, Folien oder Schichten durch das nichtstationäre Paket hindurch bewegt, oder deren Bewegung unterstützt. Das Magnetfeld kann durch einen Permanentmagneten erzeugt sein. Es kann aber auch durch einen Elektromagneten erzeugt sein, der mit Hilfe des elektrischen Stromes, der auch durch das nichtstationäre Paket fließt, erregt ist. Anstelle dieser »Hauptschluß-Motor«-Schaltung kann der Elektromagnet auch in »Nebenschluß-Motor«-Schaltung betrieben werden, indem nur ein Teil des Stromes zur Erregung des Elektromagneten abgezweigt wird. Die Motorwirkung dieser Anordnung (im Verhältnis zur Reibung) wird optimal, wenn man die Dicke der Bleche, Folien oder Schichten so groß macht, daß die Summe der elektrischen Bahnwiderstände senkrecht durch die Bleche, Folien oder Schichten im nichtstationären Paket etwa ebenso groß ist, wie die Summe aller Kontaktwiderstände.

Die thermoelektrischen Anordnungen gemäß

der Erfindung lassen sich mit Vorteil zur Umwandlung von Wärme in elektrische Energie benutzen. Wegen ihrer großen Leistungsdichte sind sie als Generatoren für Fahrzeuge ebenso geeignet wie für Kraftwerke unterschiedlicher Größe.

Sie lassen sich jedoch auch durch Zufuhr von elektrischer Leistung über den Peltier-Effekt als Wärmepumpen für Kühlung und reversible Heizung verwenden. Der elektrische Strom durch das nichtstationäre Paket erzeugt beim Übergang n → p (d. h. beim Elektronenfluß p → n) eine Wärmeabsorption, d. h. eine Abkühlung.

Beim Betrieb der thermoelektrischen Anordnung gemäß der Erfindung als Generator und Wärmepumpe wird man im allgemeinen bestrebt sein, die mechanische Reibung zwischen den Blechen, Folien oder Schichten innerhalb des nichtstationären Paketes auf ein unvermeidbares Mindestmaß zu beschränken. Man kann jedoch die thermoelektrische Anordnung der Erfindung auch dazu benutzen, um mechanische Energie (z. B. Wasserkraft) in Reibungswärme im nichtstationären Paket umzusetzen, die ihrerseits wiederum in elektrische Energie umgewandelt wird. Über die Reibung lassen sich Temperaturen > 1000° C im nichtstationären Paket erzeugen. Als Folge davon läßt sich mechanische Energie auf dem Umweg über die Reibungswärme mit Wirkungsgraden > 50% in entnehmbare elektrische Energie umwandeln.

Da die Elementschenkel der thermoelektrischen Anordnung durch Bleche, Folien oder Schichten gebildet sind, welche die Form von bewegten Bändern, Scheiben oder Ringen haben, muß deren Material — neben guter elektrischer Leitfähigkeit — auch mechanische Festigkeit und Duktilität aufweisen. Die besten Eigenschaften haben in dieser Hinsicht Metalle und Legierungen.

Es lassen sich jedoch als Elementschenkel mit Erfolgt auch Metall-Bänder, -Scheiben oder -Ringe verwenden, welche einseitig oder beidseitig mit Schichten aus thermoelektrisch p- oder n-leitendem Material belegt sind, welches für sich allein nicht duktil genug wäre.

Zur Verringerung der mechanischen Reibung und vor allem auch zur Verringerung der unvermeidbaren mechanischen Abnutzung der sich durch das nichtstationäre Paket bewegenden Bleche, Folien oder Schichten, können die aufeinander gleitenden Flächen mit einem dünnen Film eines Grenzflächen-Schmiermittels überzogen sein. Hierfür eignen sich besonders Stoffe mit einer sogenannten »Schichtgitter-Struktur«, wie z. B. Graphit, $MoS_2$, TiTe u. a. oder auch Schichten aus sogenannten »Lagermetallen«, wie z. B. Blei, Zinn, Indium, Wismut u. a.

Da die Zonen mit den großen Temperaturgradienten sich nur auf sehr kleine Distanzen erstrecken, ist es möglich, die Temperaturdifferenzen innerhalb der Dicke eines Grenzflächen-Schmierfilmes abfallen zu lassen. Man kann für jeweils zwei benachbarte aufeinander gleitende Doppelflächen zwei unterschiedliche Grenzflä-

chen-Schmiermittel benutzen, welche eine hohe Thermokraft gegeneinander haben, wie z. B. $Pr_2O_3$ mit $WSe_2$, $La_2O_3$ mit $WS_2$ u. a. Damit diese Schmierfilme nicht durch die Reibung zerstört werden, führt man sie laufend in sehr kleiner Menge den Gleitflächen zu.

Da die elektrische Kontakt-Bildung zwischen den im nichtstationären Paket aufeinander gleitenden Blechen, Folien oder Schichten grundsätzlich ein statistischer Vorgang ist, kann es nützlich sein, parallel zum nichtstationären Paket einen elektrischen Kondensator zu schalten. Dadurch lassen sich statistische Schwankungen der Spannung und des Stromes glätten.

Die Erfindung soll nachstehend an Ausführungsbeispielen näher erläutert werden. In der zugehörigen Zeichnung zeigt

Fig. 1 eine thermoelektrische Anordnung gemäß der Erfindung mit einem Thermoelement im nichtstationären Paket als Generator,

Fig. 2 eine thermoelektrische Anordnung gemäß der Erfindung mit einer Serienschaltung von vielen Thermoelementen im nichtstationären Paket als Generator mit Impuls-förmiger Abgabe der elektrischen Leistung,

Fig. 3 eine thermoelektrische Anordnung gemäß der Erfindung mit einem Thermoelement im nichtstationären Paket als Generator mit einseitiger nichtstationärer Aufheizung von Bändern,

Fig. 4a und 4b eine thermoelektrische Anordnung gemäß der Erfindung als Generator in rotationssymmetrischer Ausführung,

Fig. 5a und 5b eine thermoelektrische Anordnung gemäß der Erfindung als Wärmepumpe,

Fig. 6a und 6b eine thermoelektrische Anordnung gemäß der Erfindung als Generator mit elektromotorischem Selbstantrieb,

Fig. 7a und 7b eine thermoelektrische Anordnung gemäß der Erfindung als Generator zur Umwandlung von Reibungswärme.

Ausführungsbeispiel 1

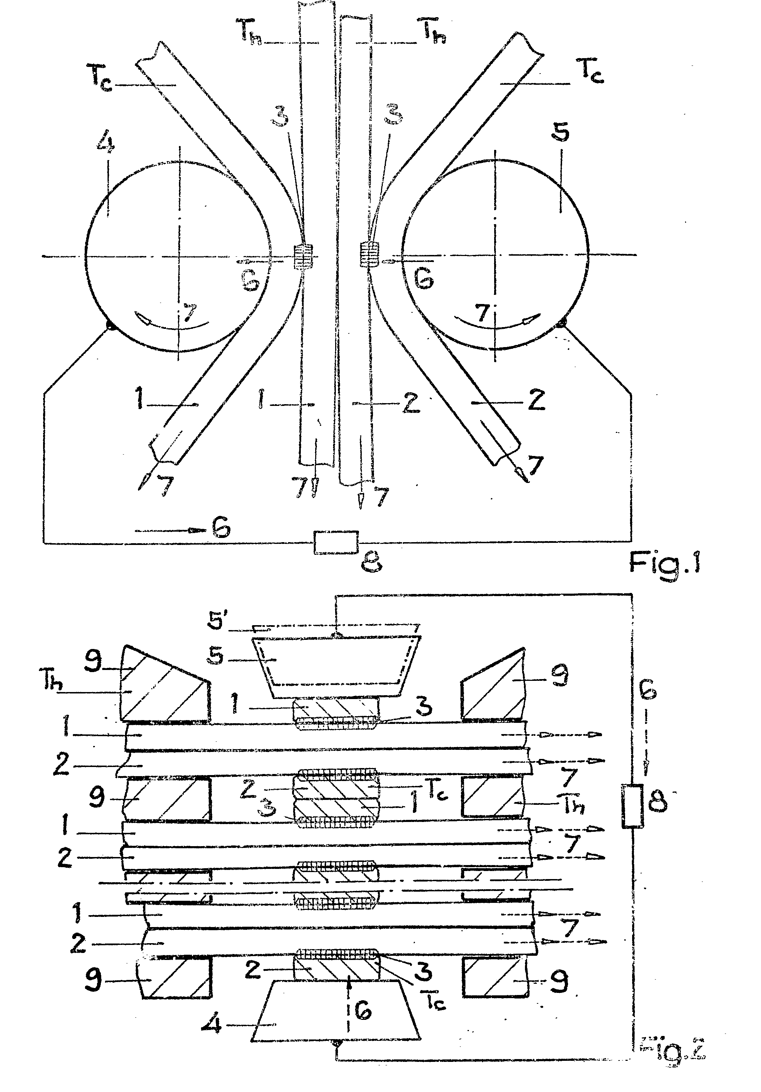

In Fig. 1 sind 1 thermoelektrisch p-leitende Bleche aus Chromnickel (87,5% Ni + 12,5% Cr) und 2 thermoelektrisch n-leitende Bleche aus Thermokonstanten (60% Cu + 40% Ni). Alle Bleche haben die Form von Bändern mit einer Dicke von 0,5 mm und einer Breite von 5 cm, die sich mit einer Geschwindigkeit 7 von 10 cm/sec bewegen. Die beiden äußeren Bänder 1 und 2 haben die Temperatur $T_c = 300°$ K, die beiden inneren Bänder befinden sich auf der Temperatur $T_h = 1100°$ K. Zwischen den beiden elektrischen Kontakten 4 und 5 in Form von (mit der Umfangsgeschwindigkeit 7) rotierenden Vollzylindern werden die kalten und heißen Bänder 1 und 2 zu einem nichtstationären Paket zusammengepreßt. Zwischen dem kalten und heißen Band 1 und dem kalten und heißen Band 2 entstehen dadurch die Zonen 3 mit den großen Temperaturgradienten. Die beiden Bänder 1 bilden den p-Schenkel und die beiden Bänder 2 bilden den n-Schenkel eines Thermoelementes, welches die Gestalt des nichtstationären Paketes 1 1 2 2 hat. Der elektrische Strom 6 fließt zwischen den elektrischen Kontakten 5 und 4 durch das nichtstationäre Paket zum Verbraucher 8.

### Ausführungsbeispiel 2

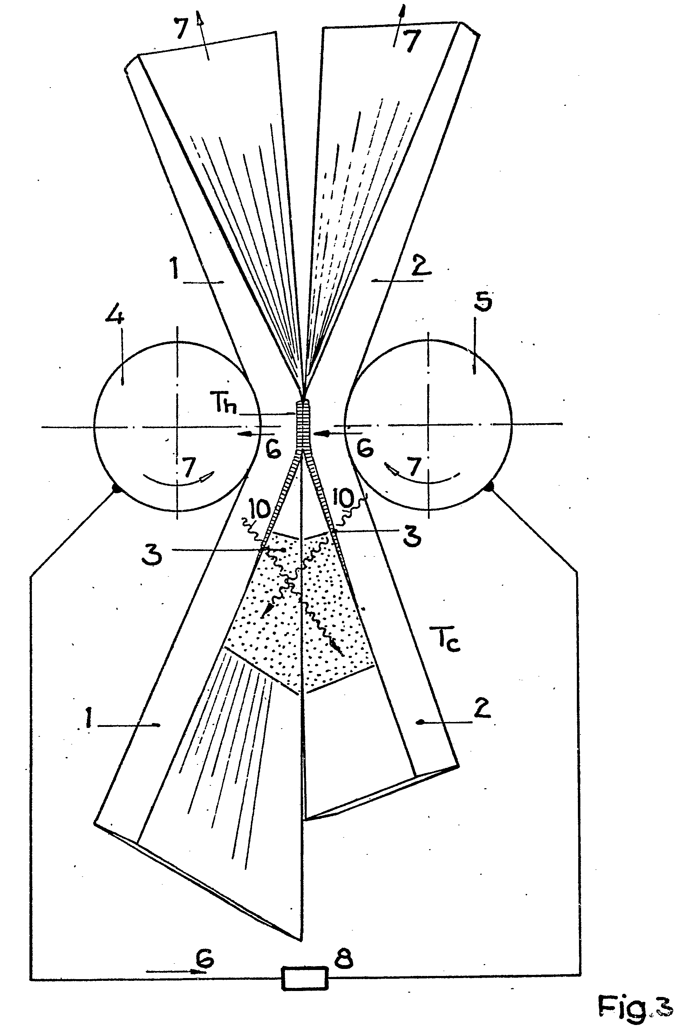

In Fig. 2 sind 1 Eisen-Bänder und 2 Nickel-Bänder mit einer Breite von 3 cm und einer Dicke von 0,1 mm. Diese Bänder 1 und 2 sind zu Paaren zusammengelegt, welche sich auf unterschiedlichen Temperaturen befinden. Die Paare 1 und 2, die sich auf der Temperatur $T_h = 1300°K$ befinden, bewegen sich in Simultan-Schritten 7 von jeweils 4 cm aus dem linken Ofen 9 in den rechten Ofen 9. Die Paare 1 und 2, die sich auf der Temperatur $T_c = 300°K$ befinden, bewegen sich phasengleich ebenfalls in Simultan-Schritten 7 von jeweils 4 cm senkrecht zur Zeichenebene. Sie sind zwischen den Paaren auf der Temperatur $T_h = 1300°K$ angeordnet. In jeder Ruhephase zwischen den Simultan-Schritten 7 werden die kalten und warmen Paare 1 und 2 mit Hilfe der elektrischen Kontakte 4 und 5, die als Preß-Stempel ausgebildet sind, mit einem Gewicht von 10 Tonnen für 0,1 Sekunden zusammen gepreßt. Dies geschieht zweimal pro Sekunde. Bei jedem Zusammenpressen entstehen zwischen den kalten und warmen Eisenbändern 1 und den kalten und warmen Nickel-Bändern 2 die Zonen 3 mit den großen Temperaturgradienten. Der elektrische Strom 6 fließt jeweils nur 0,1 Sekunden lang in Abständen von 0,4 Sekunden durch das nichtstationäre Paket aus den übereinander gepreßten Bändern 1 und 2 zwischen den elektrischen Kontakten 4 und 5 zum Verbraucher 8. 5' ist der geöffnete elektrische Kontakt 5 während der Bewegungsphase 7. Die ganze thermoelektrische Anordnung befindet sich zur Vermeidung von Korrosion in einer Stickstoff-Atmosphäre. Die Dicke des zwischen den Kontakten 4 und 5 zusammengepreßten nichtstationären Paketes beträgt 1 Meter. Es befinden sich darin insgesamt 2500 Thermoelemente mit einer Temperaturdifferenz von $T_h - T_c = 1000°K$, die elektrisch in Serie geschaltet sind. Wegen des hohen Kontaktdruckes beträgt die Summe der elektrischen Kontaktwiderstände im nichtstationären Paket nur $2 \cdot 10^{-3}$ Ohm. Bei angepaßtem Verbraucher 8 fließt ein maximaler Impulsstrom 6 von etwa 20 kA, und die thermoelektrische Anordnung gibt im zeitlichen Mittel eine elektrische Leistung von etwa 100 Kilowatt ab.

### Ausführungsbeispiel 3

In Fig. 3 ist 1 ein Band aus Chromnickel (87,5% Ni + 12,5% Cr) mit einer Dicke von 0,5 mm. 2 ist ein Nickelband mit einer Dicke von 1 mm. Beide Bänder 1 und 2 haben eine Breite von 1 Meter. Sie werden mit einer Geschwindigkeit 7 von 5 Metern pro Sekunde bewegt. Im aufgefalteten Zustand sind sie fokussierter Sonnenstrahlung 10 so hoher Intensität ausgesetzt, daß sie einseitig und nichtstationär die Oberflächentemperatur $T_h = 1400°K$ annehmen. Sofort anschließend werden sie (mit den heißen Oberflächen gegeneinander zusammengefaltet) zwischen den beiden Rollen 4 und 5 hindurchgezogen. Die Rollen 4 und 5 sind gleichzeitig die elektrischen Kontakte an dem Thermoelement, welches durch das nichtstationäre Paket aus den einseitig erhitzten Bändern 1 und 2 gebildet ist. Zwischen den einseitig auf die Temperatur $T_h$ erhitzten Oberflächen und der Masse der Bänder 1 und 2, welche sich auf der Temperatur $T_c = 400°K$ befindet, bilden sich die Zonen 3 mit den großen Temperaturgradienten aus. Der elektrische Strom 6 fließt durch das nichtstationäre Paket zwischen den elektrischen Kontakten 4 und 5 zum Verbraucher 8.

### Ausführungsbeispiel 4

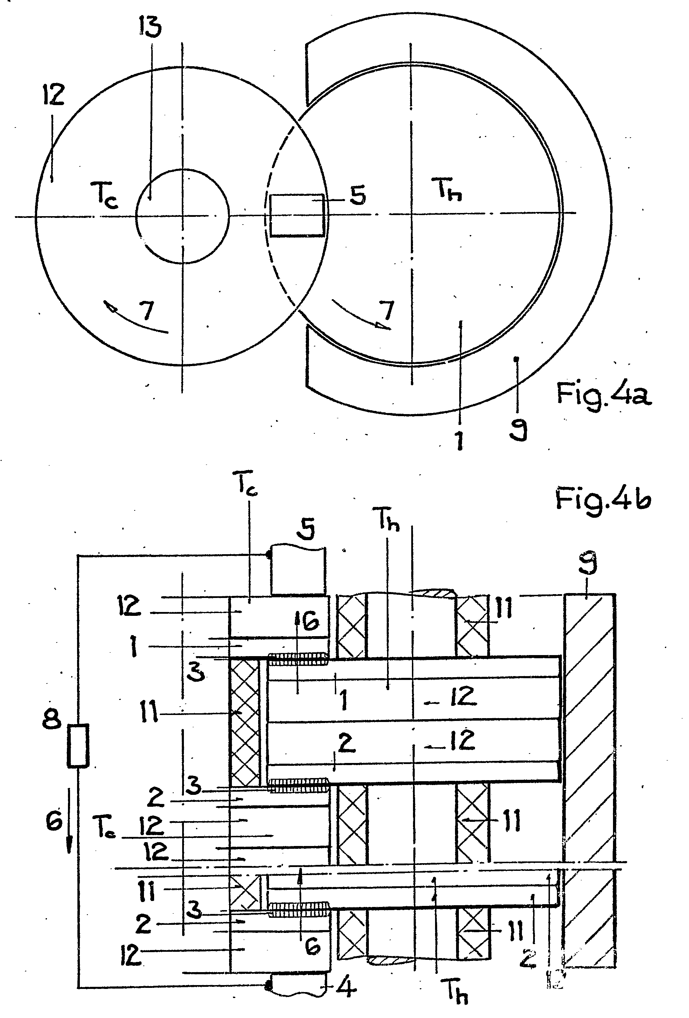

In Fig. 4b ist 1 eine $p^+$-Siliziumschicht von $1 \cdot 10^{-3}$ cm Dicke, die auf die Unterseite einer kreisförmigen Scheibe aus Molybdänblech 12 aufgebracht ist. Die Dicke des Molybdänbleches 12 beträgt 0,3 mm, der Außendurchmesser der kreisförmigen Scheibe beträgt 60 cm. 2 ist eine $n^+$-Siliziumschicht von $1 \cdot 10^{-3}$ cm Dicke, die auf die Oberseite einer kreisförmigen Scheibe aus Molybdänblech 12 aufgebracht ist. Die Dicken der Molybdänbleche 12 betragen 0,3 mm, die Außendurchmesser der kreisförmigen Scheiben betragen 60 cm. Je zwei Molybdän-Scheiben 12 mit einer $p^+$-Siliziumschicht 1 und einer $n^+$-Siliziumschicht 2 sind mit den unbeschichteten Seiten paarweise zusammengelegt. Diese Paare sind abwechselnd um eine Wasserkühlung 13 in Fig. 4a, die als Drehachse ausgebildet ist, und in einem Ofen 9 in Fig. 4a, der ebenfalls eine Drehachse enthält, so gelagert und gestapelt, daß sie sich an einer Stelle zu einem Paket überlagern. 11 sind Isolier-Ringe zwischen den Paaren. Alle kreisförmigen Scheiben aus Molybdänblech 12 mit den Schichten 1 und 2 rotieren mit der Umfangsgeschwindigkeit 7 von 30 cm/sec. Die kreisförmigen Scheiben 12, welche sich in dem Ofen 9 befinden, haben eine Temperatur $T_h = 1300°K$. Die kreisförmigen Scheiben 12 um die Wasserkühlung 13 werden auf der Temperatur $T_c = 300°K$ festgehalten. Die heißen und die kalten Paare von Molybdänscheiben 12 mit den Schichten 1 und 2 überlappen sich so, daß immer eine heiße und eine kalte Schicht 1 und eine heiße und eine kalte Schicht 2 im nichtstationären Paket aufeinander gleiten. Diese Gleitflächen sind die Zonen 3 mit den großen Temperaturgradienten. Die elektrischen Kontakte 4 und 5 sind als rollende Druck-Kontakte ausgebildet, durch welche das nichtstationäre Paket unter einem Druck von 100 kg gehalten wird. Der elektrische Strom 6 fließt über den Verbraucher 8 und zwischen den elektrischen Druck-Kontakten 4 und 5 durch das nichtstationäre Paket, welches eine Länge von 125 cm hat.

In einer anderen Variante des Ausführungsbeispiels 4 sind in Fig. 4 die p+- und n+-Siliziumschichten 1 und 2 durch eine WSe$_2$-Schicht 1 und eine Pr$_2$O$_3$-Schicht 2 ersetzt. Beide Schichten haben eine Dicke von $10^{-5}$ cm und bleiben als Folge einer laufenden Zuführung sehr kleiner Mengen WSe$_2$ bzw. Pr$_2$O$_3$ auf den Molybdänblechen 12 als dichter und zusammenhängender Film erhalten. Die Temperaturdifferenz $T_h - T_c = 1000°K$ zwischen den heißen und den kalten Molybdänblechen 12 fällt praktisch vollständig in den WSe$_2$-Schichten 1 und den Pr$_2$O$_3$-Schichten 2 ab, welche dadurch gleichzeitig die Zonen 3 mit den großen Temperaturgradienten sind. Da die Thermokraft zwischen WSe$_2$ und Pr$_2$O$_3 > 1$ mV/grd ist, gibt diese Anordnung Arbeitsspannungen $> 1000$ Volt ab. Da es sich bei den Materialien WSe$_2$ und Pr$_2$O$_3$ um Substanzen mit einem sogenannten »Schichtgitter« (wie z. B. MoS$_2$, Graphit, Bornitrid, WS$_2$, TiTe, La$_2$O$_3$ u. a.) handelt, wirken die Schichten 1 und 2 gleichzeitig als Grenzflächen-Schmiermittel. Dadurch wird die Reibung zwischen den sich ohnehin fast in gleicher Richtung im nichtstaionären Paket bewegenden Molybdänblechen 12 noch weiter verkleinert.

## Ausführungsbeispiel 5

In Fig. 5b ist 1 ein Eisenblech mit einer Dicke von 0,4 mm, das die Form eines Kreisringes mit einem Außen-Durchmesser von 50 cm hat. 2 ist ein Blech aus Thermokonstanten (60% Cu + 40% Ni) mit einer Dicke von 0,3 mm, das ebenfalls die Form eines Kreisringes mit einem Außen-Durchmesser von 50 cm hat. 12 ist ein Kupferblech mit einer Dicke von 0,3 mm, das mit einer $2 \cdot 10^{-4}$ cm dicken Bleischicht 14 zur Verminderung der Grenzflächenreibung überzogen ist, und welches ebenfalls einen Außen-Durchmesser von 50 cm hat. 11 sind Isolier-Ringe. Die Kupfer-Ringe 12 und die Paare von Ringen aus Eisenblech 1 und Thermokonstantan-Blech 2 überlappen sich so, daß ein Kupferblech 12 jeweils zwischen einem Eisenblech 1 und einem Blech aus Thermokonstantan 2 liegt, und daß zwischen zwei Kupferblechen 12 immer ein Paar von Blechen aus Eisen 1 und Thermokonstantan 2 zu liegen kommt. Die Kupferbleche 12 in Form von Ringen rotieren um eine gemeinsame Achse mit der Umfangsgeschwindigkeit 7, und die Eisenbleche 1 zusammen mit den Blechen aus Thermokonstantan 2 rotieren ebenfalls um eine andere gemeinsame Achse mit der Umfangsgeschwindigkeit 7. Die Überlappungszone der rotierenden Ringe 12 und der rotierenden Ringe 1 und 2 wird mit Hilfe der rollenden elektrischen Kontakte 4 und 5 mechanisch mit einem Gewicht von 25 kg zusammengedrückt. Sie bildet das nichtstationäre Paket, über das mit Hilfe der Stromquelle 15 der elektrische Strom 6 geleitet wird. Beim Übergang des Stromes 6 vom Thermokonstantan 2 zur Bleischicht 14 auf dem Kupfer 12 und beim Übergang des Stromes 6 von der Bleischicht 14 auf dem Kupfer 12 zum Eisen 1 wird Wärme absorbiert. Die pro Zeiteinheit absorbierte Wärme ist der Stromstärke von 6 sowie der Peltier-Spannung von Thermokonstantan 2 gegen Blei 14 bzw. von Blei 14 gegen Eisen 1 proportional. Als Folge dieser Wärmeabsorption entstehen an den aufeinander gleitenden Grenzflächen die Zonen 3 mit den großen Temperaturgradienten. Beim Übergang des Stromes 6 vom Eisen 1 zum Thermokonstantan 2 wird reversibel Wärme frei, die über die Wasserkühlung 13 abgeführt wird.

Die Eisenbleche 1 und die Thermokonstantan-Bleche 2 bleiben auf der Temperatur $T_w = 300°K$, und die Kupferbleche 12 mit der Bleischicht 14 kühlen sich auf die Temperatur $T_c$ ab.

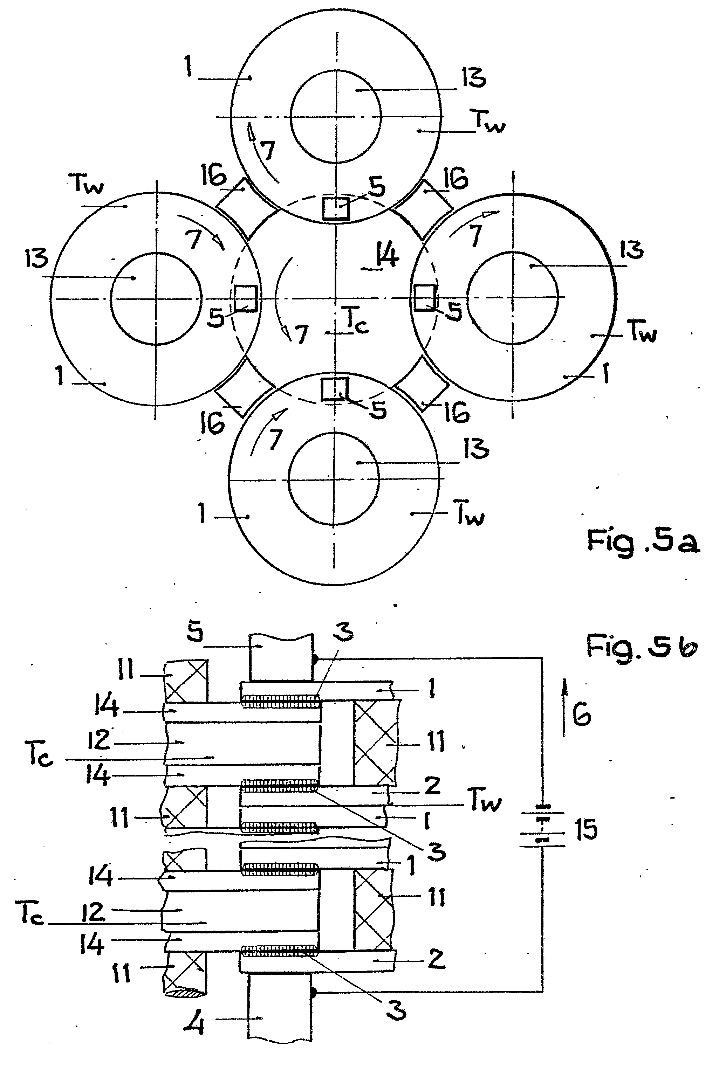

Die rotierenden Kupferbleche 12 bilden — wie in Fig. 5a gezeigt — an vier Stellen nichtstationäre Pakete wie in Fig. 5b beschrieben. Diese werden elektrisch parallel von Strom 6 durchflossen. Die im nichtstationären Paket erzeugte Reibungswärme wächst proportional mit dem mechanischen Druck P zwischen den Kontakten 4 und 5. Die Summe der elektrischen Kontaktwiderstände in einem nichtstationären Paket wächst dagegen nur mit $P^{\frac{1}{3}}$ (bei metallisch reinen Kontaktflächen) bzw. nur mit $P^{\frac{2}{3}}$ (bei Kontaktflächen mit sehr dünnen Fremdschichten). Mit Hilfe mehrerer parallelgeschalteter nichtstationärer Pakete unter jeweils kleinerem Druck P läßt sich deshalb ein bestimmter elektrischer Widerstandswert mit kleinerer Reibungswärme erzeugen als mit einem einzigen nichtstationären Paket unter dann notwendigerweise viel größerem Druck P. Die Dicke der nichtstationären Pakete beträgt 1 Meter. Sie enthalten 1000 Thermoelemente in Serie. Der elektrische Gesamtwiderstand der vier parallelgeschalteten nichtstationären Pakete beträgt etwa $2 \cdot 10^{-2}$ Ohm. Die elektrische Spannung der Batterie 15 ist 15,6 Volt. Die maximale Kühlleistung der Anordnung (für $T_c = T_w$) beträgt 6 Kilowatt. Mit Hilfe der Wärmeisolation 16 lassen sich (bei gegen Null gehender Kühlleistung) sehr tiefe Temperaturen $T_c$ erreichen.

## Ausführungsbeispiel 6

In Fig. 6b ist 1 eine $1 \cdot 10^{-3}$ cm dicke Schicht aus der Legierung »Pallaplat Plus« (95% Pt + 5% Rh) und 2 eine $1 \cdot 10^{-3}$ cm dicke Schicht aus der Legierung »Pallaplat Minus« (52% Au + 46% Pd + 2% Pt).

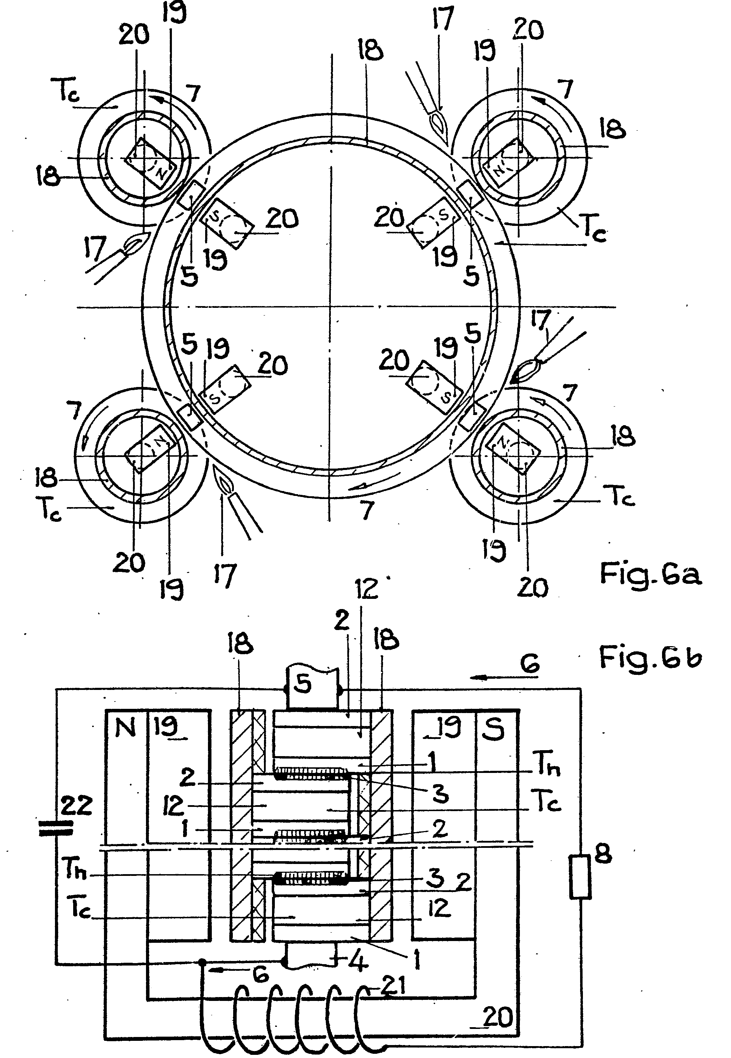

Beide Schichten 1 und 2 sind auf unterschiedliche Seiten eines Eisenbleches 12 aufplattiert, welches eine Dicke von 0,08 mm hat. Die Eisenbleche 12 mit den Plattierungsschichten 1 und 2 haben die Form von größeren und kleineren Kreisringen. Sie sind — wie in Fig. 6a

gezeigt — konzentrisch um die Keramik-Rohre 18 gelagert und unter Zwischenschaltung der Isolier-Ringe 11 gestapelt. Die um die kleineren Keramik-Rohre 18 gelagerten Eisenbleche 12 (mit den Schichten 1 und 2) überlappen sich mit den um das größere Keramik-Rohr 18 gelagerten Eisenblechen 12 (mit den Schichten 1 und 2) so, daß immer eine Schicht 1 mit einer Schicht 2 in Kontakt steht. Diese Überlappungen zwischen großen und kleinen Eisenblechen 12 bestehen an vier Stellen, wo sie nichtstationäre Pakete entsprechend Fig. 6b bilden. Der Außen-Durchmesser der großen Kreisringe aus Eisenblech 12 um das große Keramik-Rohr 18 ist 2 Meter, der Außen-Durchmesser der kleineren Kreisringe aus Eisenblech 12 um die kleineren Keramik-Rohre 18 ist 50 cm. Alle Eisenbleche 12 rotieren mit der Umfangsgeschwindigkeit 7 von 50 cm/sec. Durch die elektrischen Kontakte 4 und 5 werden die nichtstationären Pakete mit einem Gewicht von je 50 kg belastet. Mit Hilfe von vier Wasserstoff-Sauerstoff-Flammen 17, welche die Form einer Zeile haben, deren Länge gleich der Länge eines nichtstationären Paketes ist, werden die Plattierungsschichten 1 und 2 auf den großen und auf den kleineren Eisenblechen 12 jeweils kurz vor ihrem Eintritt in ein nichtstationäres Paket auf die Oberflächentemperatur $T_h = 1500°K$ aufgeheizt. Dadurch entstehen die Zonen 3 mit den großen Temperaturgradienten, die im nichtstationären Paket die heißen Kontakte der elektrisch in Serie geschalteten Thermoelemente sind. Durch Luftkühlung werden die kalten Kontakte auf der Temperatur $T_c = 500°K$ gehalten. Die elektrischen Ströme 6 durch die vier nichtstationären Pakete sind parallel gerichtet. Sie fließen, bevor sie dem Verbraucher 8 zugeführt werden, durch die Erregerspulen 21 von vier Elektromagneten 20, zwischen deren Polschuhen 19 — mit dem Nordpol N und dem Südpol S — sich jeweils ein vom Strom 6 durchflossenes nichtstationäres Paket befindet. Dadurch wird eine motorische Kraft auf die rotierenden Eisenbleche 12 in Richtung ihrer Bewegung 7 ausgeübt. Die nichtstationären Pakete haben eine Länge von 2 Metern. Jedes nichtstationäre Paket enthält $2 \cdot 10^4$ Thermoelemente in Serienschaltung und hat einen elektrischen Widerstand von 0,2 Ohm. Die Leerlauf-Spannung beträgt 1200 Volt. Zwischen die elektrischen Kontakte 4 und 5 ist parallel zu jedem nichtstationären Paket ein Kondensator 22 zur Glättung des Stromes 6 geschaltet.

### Ausführungsbeispiel 7

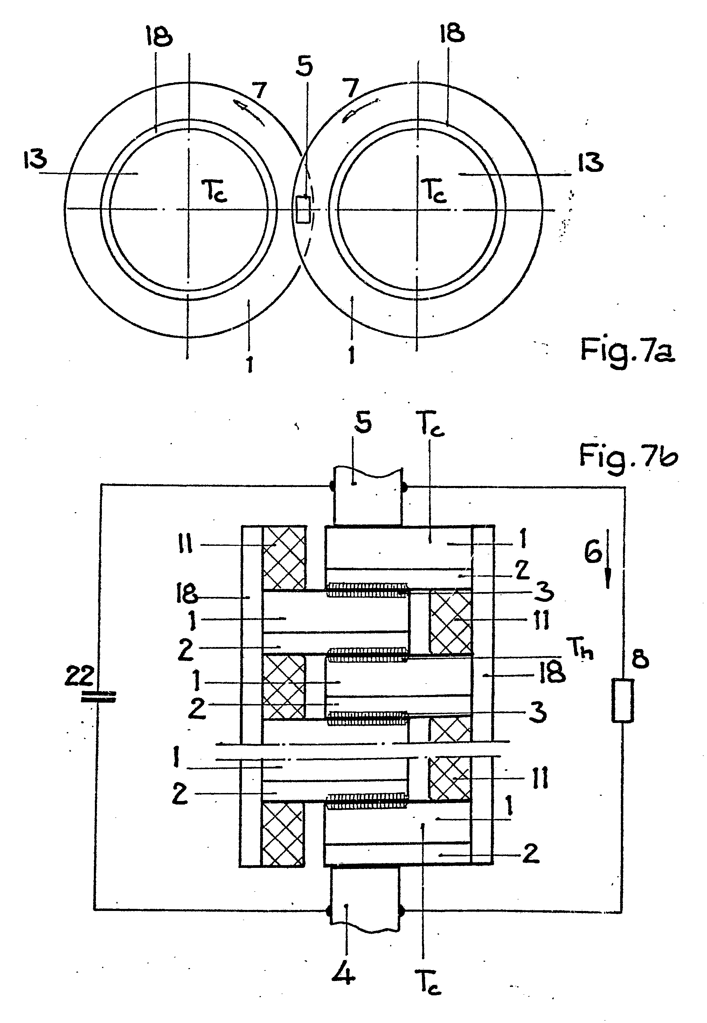

In Fig. 7b ist 1 ein Wolframblech mit einer Dicke von 0,8 mm. 2 ist eine Wolfram-Carbidschicht in einer Dicke von 0,2 mm, die auf das Wolframblech 1 aufgebracht ist. Jedes Wolframblech 1 mit der Wolfram-Carbidschicht 2 hat die Form eines Kreisringes mit einem Außen-Durchmesser von 40 cm. Um zwei Keramik-Rohre 18, die eine Wasserkühlung 13 haben, sind die Kreisringe aus Wolframblech 1 mit der Wolfram-Carbidschicht 2 so gelagert und unter Verwendung von Isolier-Ringen 11 so gestapelt, daß sie sich an einer Stelle überlappen (Fig. 7a). Bei dieser Überlappung kommen immer ein Wolframblech 1 und eine Wolfram-Carbidschicht 2 miteinander in Kontakt. Die Wolframbleche 1 mit den Wolfram-Carbidschichten 2 um das linke Keramik-Rohr 18 und um das rechte Keramik-Rohr 18 in Fig. 7a rotieren mit dem gleichen Betrag der Umfangsgeschwindigkeit 7 von 120 cm/sec. Sie bewegen sich im nichtstationären Paket zwischen den elektrischen Kontakten 4 und 5, aber in entgegengesetzter Richtung. Der Druck zwischen den Kontakten 4 und 5 auf das nichtstationäre Paket mit einer Länge von 80 cm beträgt 50 kg. Obwohl die Wolfram-Carbidschichten 2 mit ihrer hexagonalen Struktur einen relativ kleinen Reibungskoeffizienten haben, werden im nichtstationären Paket etwa 100 Kilowatt mechanisches Leistungs-Äquivalent in Reibungswärme umgesetzt. An den Reibungsflächen zwischen den Wolfram-Blechen 1 und den Wolfram-Carbidschichten 2 entstehen durch die Reibung die Zonen 3 mit den großen Temperaturgradienten bei Temperaturspitzen bis zu 2000°C. Zur Vermeidung von Oxydationsprozessen befindet sich die Anordnung in einer Helium-Atmosphäre. Im nichtstationären Paket zwischen den Kontakten 4 und 5 sind 800 Thermoelemente in Serie geschaltet. Die heißen Kontaktstellen der Thermoelemente sind die aufeinander reibenden Oberflächen von Wolfram 1 und Wolfram-Carbid 2. Die kalten Kontaktstellen der Thermoelemente sind die innerhalb eines Wolframbleches 1 liegenden Übergänge von Wolfram 1 nach Wolfram-Carbid 2. Dem Verbraucher 8 können über den elektrischen Strom 6 bis zu 85% der zur Überwindung der Reibung benötigten mechanischen Energie in Form von elektrischer Energie zugeführt werden. Zur Glättung des Stromes 6 ist zwischen die Kontakte 4 und 5 der Kondensator 22 geschaltet.

### Patentansprüche

1. Thermoelektrische Anordnung mit großen Temperaturgradienten, dadurch gekennzeichnet, daß die Elementschenkei eines Thermoelementes durch Bleche, Folien oder Schichten (1, 2) gebildet sind, welche die Form von Bändern, Scheiben oder Ringen haben und mechanisch so bewegt sind, daß sie mindestens an einer Stelle ein nichtstationäres Paket bilden, in dem ihre Oberflächen aufeinanderfolgend einander berühren, welches Paket abwechselnd thermoelektrische p/n- und n/p-Übergänge enthält, zwischen denen eine Temperaturdifferenz (3) besteht, und daß ein elektrischer Strom durch das nichtstationäre Paket senkrecht zur Oberfläche der Bleche, Folien oder Schichten fließt.

2. Thermoelektrische Anordnung nach An-

spruch 1, dadurch gekennzeichnet, daß das nichtstationäre Paket unter mechanischem Druck steht.

3. Thermoelektrische Anordnung nach einem der vorhergehenden Ansprüche, dadurch gekennzeichnet, daß das nichtstationäre Paket durch einseitiges Aufheizen von thermoelektrisch p- und n-leitenden Blechen, Folien oder Schichten mit Hilfe von Plasma oder Strahlung und anschließendem Zusammenführen der heißen Seiten und der kalten Seiten der Bleche, Folien oder Schichten zustande kommt.

4. Thermoelektrische Anordnung nach einem der vorhergehenden Ansprüche, dadurch gekennzeichnet, daß das nichtstationäre Paket durch Zusammenführen von abwechselnd warmen und kalten Paaren aus thermoelektrisch n- und p-leitenden Blechen, Folien oder Schichten zustande kommt.

5. Thermoelektrische Anordnung nach einem der vorhergehenden Ansprüche, dadurch gekennzeichnet, daß die mechanische Bewegung der thermoelektrisch n- und p-leitenden Bleche, Folien oder Schichten in Form von Bändern, Scheiben oder Ringen durch die elektromotorische Kraft auf das stromdurchflossene nichtstationäre Paket in einem Magnetfeld zustande kommt oder unterstützt wird.

6. Thermoelektrische Anordnung nach einem der vorhergehenden Ansprüche, dadurch gekennzeichnet, daß sie unter Zuführung von Wärme als elektrischer Generator arbeitet.

7. Thermoelektrische Anordnung nach einem der Ansprüche 1 bis 5, dadurch gekennzeichnet, daß die Temperaturdifferenzen im nichtstationären Paket durch elektrischen Strom verursacht sind, und daß die Anordnung unter Zuführung von elektrischer Leistung als Wärmepumpe arbeitet.

8. Thermoelektrische Anordnung nach einem der Ansprüche 1, 2 oder 5, dadurch gekennzeichnet, daß die Temperaturdifferenzen im nichtstationären Paket durch mechanische Reibung zwischen den thermoelektrisch n-leitenden und den thermoelektrisch p-leitenden Blechen, Folien oder Schichten erzeugt sind, und daß die Reibungswärme in elektrische Energie umgewandelt wird.

9. Thermoelektrische Anordnung nach einem der vorhergehenden Ansprüche, dadurch gekennzeichnet, daß elektrisch parallel zum nichtstationären Paket ein Kondensator geschaltet ist.

10. Thermoelektrische Anordnung nach einem der vorhergehenden Ansprüche, dadurch gekennzeichnet, daß mehrere nichtstationäre Pakete elektrisch parallel geschaltet sind.

11. Thermoelektrische Anordnung nach einem der vorhergehenden Ansprüche, dadurch gekennzeichnet, daß als Material für die Elementschenkel Metalle, Metall-Legierungen oder metallisch leitende Verbindungen verwendet sind.

12. Thermoelektrische Anordnung nach einem der vorhergehenden Ansprüche, dadurch gekennzeichnet, daß als Elementschenkel metallisch leitende Bänder, Scheiben oder Ringe verwendet sind, die einseitig oder beidseitig mit Schichten aus thermoelektrisch n-leitendem oder p-leitendem Material belegt sind.

13. Thermoelektrische Anordnung nach einem der vorhergehenden Ansprüche, dadurch gekennzeichnet, daß zur Verringerung der Reibung und des mechanischen Abriebs die im nichtstationären Paket aufeinander gleitenden Bänder, Scheiben oder Ringe mit einem dünnen Film eines Grenzflächen-Schmiermittels überzogen sind.

14. Thermoelektrische Anordnung nach einem der vorhergehenden Ansprüche, dadurch gekennzeichnet, daß im nichtstationären Paket für benachbarte aufeinander gleitende Flächen zwei unterschiedliche Grenzflächen-Schmiermittel in Form von dünnen Filmen verwendet sind, die eine Thermokraft gegeneinander haben.

## Claims

1. A thermo-electric arrangement having great temperature gradients, characterized in that the individual limbs of a thermocouple are formed by sheets, films or layers in the form of strips, discs or rings which are mechanically moved in a manner to form at least at one point a non-stationary stack in which their surfaces are in contact with each other and which comprises an alternate sequence of p/n and n/p transitions with a temperature difference existing therebetween, and that an electric current passes through the said non-stationary stack in a direction vertical to the surface of the said sheets, films or layers.

2. A thermo-electric arrangement in accordance with claim 1, characterized in that the non-stationary stack is subjected to a mechanical pressure.

3. A thermo-electric arrangement in accordance with any of the preceding claims, characterized in that the non-stationary stack is formed by unilaterally heating thermo-electric p- and n-conductive sheets, films or layers by means of plasma or radiation, and subsequently joining the hot sides and the sold sides of the sheets, films or layers.

4. A thermo-electric arrangement in accordance with any of the preceding claims, characterized in that the non-stationary stack is formed by alternately joining hot and cold pairs of thermo-electrically n- and p-conductive sheets, films or layers to stack configuration.

5. A thermo-electric arrangement in accordance with any of the preceding claims, characterized in that the mechanical movement of the thermo-electrically n- and p-conductive sheets, films or layers taking the form of strips, discs or rings is brought about or supported by the electromotive force acting on the current-carrying non-stationary stack in a magnetic field.

6. A thermo-electric arrangement in accordance with any of the preceding claims, characterized in that it acts as an electric generator when heat is supplied to it.

7. A thermo-electric arrangement in accordance with any of claims 1 to 5, characterized in that the temperature differences in the non-stationary stack are caused by electric current, and that the arrangement acts as a heat pump when electric power is supplied to it.

8. A thermo-electric arrangement in accordance with any of claim 1, 2 or 5, characterized in that the temperature differences in the non-stationary stack are produced by mechanical friction between the thermo-electrically n-conductive and the thermo-electrically p-conductive sheets, films or layers, and that the frictional heat is converted into electric energy.

9. A thermo-electric arrangement in accordance with any of the preceding claims, characterized in that a capacitor is electrically connected in parallel to the non-stationary stack.

10. A thermo-electric arrangement in accordance with any of the preceding claims, characterized in that a plurality of non-stationary stacks are electrically connected in parallel.

11. A thermo-electric arrangement in accordance with any of the preceding claims, characterized in that the material used for the limbs of the thermocouple consists of metal, metal alloys or metallic conductive compounds.

12. A thermo-electric arrangement in accordance with any of the preceding claims, characterized in that the individual thermocouple limbs consist of metallic conductive strips, discs or rings coated either on one or on both sides with layers of a thermo-electrically n-conductive or p-conductive material.

13. A thermo-electric arrangement in accordance with any of the preceding claims, characterized in that to reduce the friction and the mechanical wear, the strips, discs or rings sliding upon each other within the non-stationary stack are coated with a thin film of an interface lubricant.

14. A thermo-electric arrangement in accordance with any of the preceding claims, characterized in that two different interface lubricants in form of thin films having opposed thermo-electric forces are used for neighbouring faces sliding upon each other within the non-stationary stack.

## Revendications

1. Dispositif thermo-électrique à fort gradient de température présentant les caractéristiques suivantes: il s'agit d'un thermo-couple dont les branches sont formées par des tôles, feuilles ou couches ayant la forme de feuillards, disques ou anneaux et subissant des déplacements mécaniques tels qu'ils constituent en au moins un endroit un paqeut non stationnaire au sein duquel leurs surfaces entrent successivement en contact les unes avec les autres; le paquet contient ainsi alternativement des jonctions thermo-électriques p/n et n/p entre les quelles il existe une différence de température; enfin, le paquet est le siège d'un courant èlectrique circulant perpendiculairement à la surface des tôles, feuilles ou couches.

2. Dispositif thermo-électrique tel que décrit à la revendication n° 1, mais caractérisé par le fait que le paquet non stationnaire subit une pression exercée mécaniquement.

3. Dispositif thermo-électrique tel que décrit en une des revendications ci-dessus, mais caractérisé par le fait que le paquet non stationnaire se forme par chauffage sur une seule face de tôles, feuilles ou couches présentant une conductivité thermo-électrique de type p ou n au moyen de plasma ou par rayonnement, puis par rénion des faces chaudes et des faces froides des tôles, feuilles ou couches.

4. Dispositif thermo-électrique tel que décrit en une des revendications ci-dessus, mais caractérisé par le fait que le paquet non stationnaire se forme par wéunion de paires, alternativement chaudes et froides, de tôles, feuilles ou couches présentant une conductivité thermo-électrique de type n ou p.

5. Dispositif thermo-électrique tel que décrit en une des revendications ci-dessus, mais caractérisé par le fait que les déplacements mécaniques des tôles, feuilles ou couches présentant une conductivité thermo-électrique de type n ou p et en forme de feuillards, disques ou anneaux prennent naissance ou sont favorisés par l'effet d'une force électromotrice agissant sur le paquet non stationnaire parcouru par un courant et plongé dans un champ magnétique.

6. Dispositif thermo-électrique tel que décrit en une des revendications ci-dessus, mais caractérisé par le fait qu'il fonctionne en générateur d'électricité grâce à un apport de chaleur.

7. Dispositif thermo-électrique tel que décrit en une des revendications n° 1 à 5 ci-dessus, mais caractérisé par le fait que les différences de température sont provoquées dans le paquet non stationnaire par un courant électrique, le dispositif fonctionnant en pompe à chaleur grâce à un apport de puissance électrique.

8. Dispositif thermo-électrique tel que décrit en une des revendications n° 1, 2 ou 5 ci-dessus, mais caractérisé par le fait que les différences des température sont provoquées dans le paquet non stationnaire par des frottements mécaniques entre les tôles, feuilles ou couches présentant une conductivité thermo-électrique de type n et celles présentant une conductivité thermo-électrique de type p, la chaleur dégagée par ces frottements étant transformée en énergie électrique.

9. Dispositif thermo-électrique tel que décrit en une des revendications ci-dessus, mais caractérisé par le fait que le paquet non stationnaire est ponté électriquement par un condensateur connecté en paralléle avec lui.

10. Dispositif thermo-électrique tel que décrit en une des revendications ci-dessus, mais caractérisé par le fait que plusieurs paquets non stationnaires sont réunis électriquement en paralléle.

11. Dispositif thermo-électrique tel que décrit en une des revendications ci-dessus, mais caractérisé par le fait que les branches du thermo-couple sont constituées par des connexions en métal, en alliage(s) métallique(s), ou présentant une conductivité métallique.

12. Dispositif thermo-électrique tel que décrit en une des revendications ci-dessus, mais caractérisé par le fait que sont utilisés comme branches du thermo-couple des feuillards, disques ou anneaux présentant une conductivité métallique et revêtus sur leurs deux faces ou sur une seule de couches d'une matière présentant une conductivité thermo-électrique de type n ou p.

13. Dispositif thermo-électrique tel que décrit en une des revendications ci-dessus, mais caractérisé par le fait qu'afin de réduire les frottemants et l'abrasion mécanique, les feuillards, disques ou anneaux qui glissent les uns sur les autres dans le paquet non stationnaire sont revêtus d'un mince film d'une matière lubrifiant les faces en contact.

14. Dispositif thermo-électrique tel que décrit en une des revendications ci-dessus, mais caractérisé par le fait que la lubrification des faces adjacentes qui glissent les unes sur les autres dans le paquet non stationnaire est assurée par deux matières différentes appliquées en minces film présentant l'un par rapport à l'autre une certaine force thermo-électrique.

0 000 475

Fig.1

Fig.3

Fig.4a

Fig.4b

0 000 475

Fig. 5a

Fig. 5b

17

Fig.6a

Fig.6b

Fig.7a

Fig.7b